# EUROPEAN PATENT APPLICATION

(11) **EP 2 267 183 A1**
(43) Date of publication of application: **29.12.2010**
(21) Application number: 09723417.3
(22) Date of filing: 18.03.2009
(51) Int. Cl.: C23C 16/52

(54) **ATOMIC LAYER FILM-FORMING DEVICE**

(30) Priority: 21.03.2008 JP 2008074544
(71) Applicant: Mitsui Engineering & Shipbuilding Co., Ltd., Chuo-ku Tokyo 104-8439 (JP)
(72) Inventor: MURATA, Kazutoshi, Tamano-shi Okayama 706-8651 (JP)
(74) Representative: von Puttkamer · Berngruber
(86) International application number: PCT/JP2009/055297
(87) International publication number: WO 2009/116576

(57) **Abstract**

An atomic layer film forming apparatus includes a plurality of gas supply pipes (121 - 123) for supplying a source gas to a film forming chamber (101), and an exhaust portion (105) for evacuating the inside of the film forming chamber (101). Valves (131 - 133) are attached to the gas supply pipes (121 - 123), respectively. In the film forming chamber (101), film forming chamber monitors (141 - 149) are arranged to measure a state in the film forming chamber (101). Based on the results of measurement by the film forming chamber monitors (141 - 149), a controller (107) controls the openings or opening times of the valves (131 - 133). The atomic layer film forming apparatus can improve gas uniformity when a plurality of gas supply ports are used.

## Description

### Technical Field

The present invention relates to an atomic layer film forming apparatus capable of forming a thin film for each of atomic and molecular layers.

### Background Art

Recently, ALD (Atomic Layer Deposition) capable of forming a thin film for each of atomic and molecular layers is receiving attention as a technique having various features including one capable of forming a high-quality thin film more uniformly at a temperature as low as about 300°C or less. The ALD method is a technique of forming a thin film for each atomic layer by alternately supplying, to a substrate, raw materials of respective elements which constitute a film to be formed. In the ALD method, the surface adsorbs only one or n (n is an integer of 2 or more) layers while supplying raw materials of respective elements so that no unwanted raw material contributes to the growth. This is called a growth self-limiting function. The ALD method has both very excellent shape adaptability and film thickness controllability, compared to general CVD. Applications of the ALD method to the manufacture of large-screen flat panel displays are being examined as a technique capable of forming a uniform thin film in a wider area at lower temperature with good reproducibility.

As an ALD apparatus which copes with large screens, there is proposed a lateral apparatus which supplies gas parallel to a substrate because the ALD apparatus targets a rectangular substrate more than several ten cm on a side. As is well known, the lateral apparatus supplies gas parallel to a substrate, and thus has a simple arrangement and can be easily applied to large-size substrates. As described above, the ALD method has the growth self-limiting function, and the state of a formed film is not so affected by the distribution of supplied gas in comparison with other chemical vapor deposition methods. Hence, even if the distance from the gas supply port greatly changes along with the increase in substrate size, the ALD method can be expected to form a uniform film on the entire substrate.

The present inventors have confirmed that even when the lateral thin film forming apparatus executes atomic layer deposition, for example, the film state distribution appears between the center region of the substrate where gas flows, and a region at the end of the substrate that is spaced apart from the center region. This distribution stands out much more as the substrate size increases. To solve this, Japanese Patent Laid-Open No. 2007-157885 proposes a technique of increasing the number of gas supply ports to supply gas from a wider region on one side. This technique prevents nonuniformity by supplying gas uniformly.

### Disclosure of Invention

### Problems to be Solved by the Invention

However, the present inventors have also found out that no uniformity is sometimes ensured even if a plurality of gas supply ports are used to supply (spray) gas uniformly from them. In this way, the conventional technique cannot always ensure uniformity even using a plurality of gas supply ports.

The present invention has been made to solve the above problems and has as its object to improve gas uniformity when a plurality of gas supply ports are used.

### Means of Solution to the Problems

An atomic layer film forming apparatus according to the present invention comprises a film forming chamber in which a substrate subjected to film formation is arranged, a plurality of gas supply pipes which supply, from a first side of the film forming chamber to the film forming chamber, a gas containing a raw material for forming a thin film on the substrate, a plurality of valves which are attached to the plurality of gas supply pipes, an exhaust portion which evacuates an inside of the film forming chamber from a second side of the film forming chamber that faces the first side, a film forming chamber state measurement unit which is arranged in the film forming chamber and measures a state on the substrate in the film forming chamber, and a controller which individually controls at least one of openings and opening times of the plurality of valves based on a result of measurement by the film forming chamber state measurement unit.

### Effects of the Invention

According to the present invention, at least either the opening or opening time of each valve is individually controlled based on the result of measuring a state on a substrate in the film forming chamber. The present invention can therefore improve gas uniformity when a plurality of gas supply ports are used.

### Brief Description of Drawings

Fig. 1 is a view showing the planar arrangement of an atomic layer film forming apparatus in an embodiment of the present invention;
Fig. 2 is a view showing the sectional arrangement of the atomic layer film forming apparatus shown in Fig. 1; and
Fig. 3 is a view showing the sectional arrangement of an atomic layer film forming apparatus in another embodiment of the present invention.

### Best Mode for Carrying Out the Invention

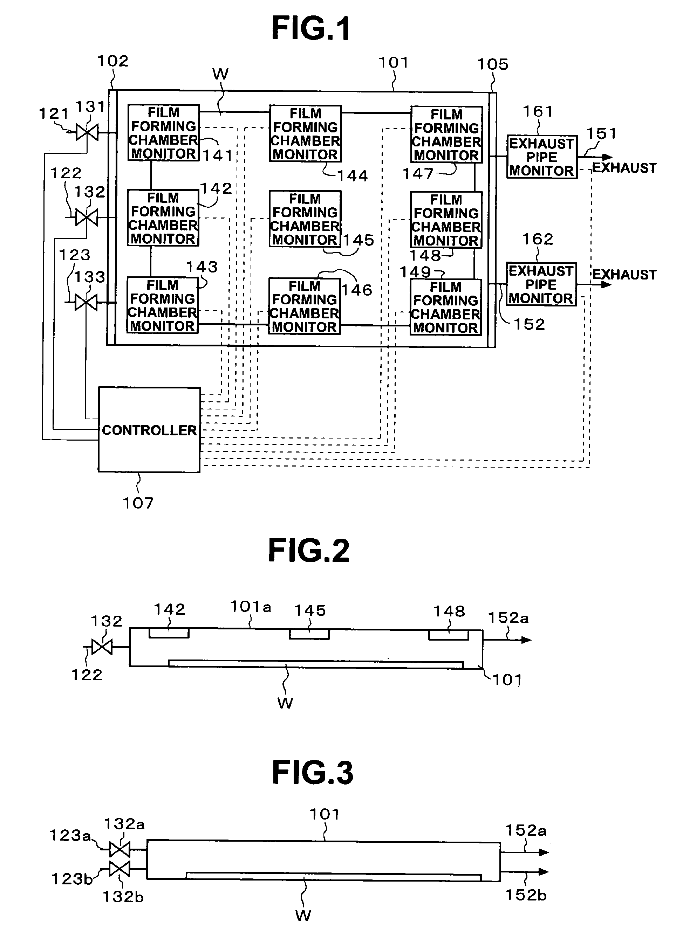

An embodiment of the present invention will now be described with reference to the accompanying drawings. Fig. 1 is a view showing the planar arrangement of an atomic layer film forming apparatus in the embodiment of the present invention.

The atomic layer film forming apparatus in the embodiment includes a film forming chamber 101, gas supply pipes 121, 122, and 123, and valves 131, 132, and 133. A source gas or oxidizing gas (e.g., ozone gas) is introduced into the film forming chamber 101 to form a thin film on a target substrate W. A gas containing a raw material for forming a thin film is supplied from one side (first side) of the film forming chamber 101 to a region in the film forming chamber 101 via the gas supply pipes 121, 122, and 123. The valves 131, 132, and 133 are attached to the gas supply pipes 121, 122, and 123, respectively.
Although not shown, as is well known, a gas supply mechanism including an evaporator for evaporating a liquid raw material is connected to the gas supply pipes 121 to 123 to be able to supply a source gas such as trimethylaluminum (TMA) gas, an oxidizing gas such as ozone gas, or a purge gas such as argon (Ar) gas.

Further, the atomic layer film forming apparatus includes film forming chamber monitors (film forming chamber state measurement units) 141, 142, 143, 144, 145, 146, 147, 148, and 149 which are arranged in the film forming chamber 101.

The atomic layer film forming apparatus also includes exhaust pipes 151 and 152, and exhaust pipe monitors (exhaust pipe internal state measurement units) 161 and 162. The exhaust pipes 151 and 152 are used to evacuate the inside of the film forming chamber 101 from the other side (second side) of the film forming chamber 101. The exhaust pipe monitors 161 and 162 are arranged midway along the exhaust pipes 151 and 152, respectively. Although not shown, as is well known, an exhaust mechanism such as a dry vacuum pump is connected to the exhaust pipes 151 and 152. The inside of the film forming chamber 101 can be evacuated using the dry vacuum pump and the exhaust pipes 151 and 152. A gas supply portion 102 formed from the gas supply pipes 121 to 123, and an exhaust portion 105 formed from the exhaust pipes 151 and 152 are arranged to face each other in the film forming chamber 101.

In addition, the atomic layer film forming apparatus includes a controller 107 which individually controls the openings or opening times of the valves 131 to 133 based on the results of measurement by the film forming chamber monitors 141 to 149 and the exhaust pipe monitors 161 and 162.

For example, as shown in Fig. 2, the film forming chamber monitors 141 to 149 are arranged on a ceiling 101a above the substrate W in the film forming chamber 101.
The film forming chamber monitors 141, 142, and 143 are arranged on the side of the gas supply portion 102 in the film forming chamber 101. The film forming chamber monitors 147, 148, and 149 are arranged on the side of the exhaust portion 105 in the film forming chamber 101. The film forming chamber monitors 144, 145, and 146 are arranged at an intermediate position between the gas supply side and the exhaust side in the film forming chamber.

For example, the film forming chamber monitors 141, 144, and 147 are arrayed on the left side (left line) in the gas flow direction from the gas supply side to the exhaust side. The film forming chamber monitors 142, 145, and 148 are arrayed at the center (center line) in the gas flow direction from the gas supply side to the exhaust side. The film forming chamber monitors 143, 146, and 149 are arrayed on the right side (right line) in the gas flow direction from the gas supply side to the exhaust side.
In the film forming chamber 101, 3 x 3 = 9 film forming chamber monitors 141 to 149 are arranged on the ceiling, and monitor a state on the substrate W, including a thin film formed on it, in the film forming chamber 101.

The film forming chamber monitors 141 to 149 can be crystal oscillation monitors (e.g., crystal oscillation film thickness monitor CRTM-9000 available from ULVAC). This monitor can measure the mass of a film which is deposited on a detector formed from a crystal oscillator, similarly to that deposited on the substrate W, and can measure the film thickness based on the measured mass. Note that the monitor also indirectly measures the amount of gas flowing at a monitor arrangement location (on a substrate in the film forming chamber 101). Hence, the monitor functions as a film thickness measurement unit and gas amount measurement unit.

In the atomic layer film forming apparatus having the film forming chamber monitors 141 to 149, a thin film identical to one formed on the substrate W in the film forming chamber 101 is formed on the detector. The atomic layer film forming apparatus can, therefore, indirectly measure the thickness of the thin film formed on the substrate W. The film forming chamber monitors 141 to 149 indirectly measure the distribution of the thickness of the thin film formed on the substrate W. Also, the film forming chamber monitors 141 to 149 indirectly measure the distribution of the amount of gas flowing on the substrate W.

Based on the measurement results, the controller 107 individually controls the openings or opening times of the valves 131 to 133. For example, when film thicknesses measured by the film forming chamber monitors 141, 144, and 147 arrayed on the left line are larger than those measured by the film forming chamber monitors on the remaining lines, the controller 107 decreases the amount of gas supplied through the gas supply pipe 121 by decreasing the opening of the valve 131 or shortening its opening time.

For example, when gas amounts measured by the film forming chamber monitors 141, 144, and 147 arrayed on the left line are larger than those measured by the film forming chamber monitors on the remaining lines, the controller 107 decreases the amount of gas supplied through the gas supply pipe 121 by decreasing the opening of the valve 131 or shortening its opening time.

The film forming chamber monitors 141 to 149 can be ellipsometers. The ellipsometer can measure the film thickness and refractive index of a thin film formed on the substrate W. Thus, the ellipsometer functions as a film thickness measurement unit and refractive index measurement unit. The atomic layer film forming apparatus having the film forming chamber monitors 141 to 149 can directly measure the thickness of a thin film formed on the substrate W in the film forming chamber 101. Accordingly, the film forming chamber monitors 141 to 149 measure the distribution of the thickness of the thin film formed on the substrate W.

Based on the measurement results, the controller 107 individually controls the openings or opening times of the valves 131 to 133. For example, when film thicknesses measured by the film forming chamber monitors 141, 144, and 147 arrayed on the left line are larger than those measured by the film forming chamber monitors on the remaining lines, the controller 107 decreases the amount of gas supplied through the gas supply pipe 121 by decreasing the opening of the valve 131 or shortening its opening time.

Also, the film forming chamber monitors 141 to 149 can be particle monitors (foreign substance measurement units available from, e.g., HACH Ultra Analytics) which measure the state of a foreign substance (generated dust) generated in a space above the substrate W. The atomic layer film forming apparatus having the film forming chamber monitors 141 to 149 can measure the state of a particle (foreign substance or generated dust) generated above the substrate W in the film forming chamber 101. The state of generated dust is affected by the amount of gas flowing on the substrate W. For example, particles are readily generated in a region where gas is supplied more than necessary. Hence, the film forming chamber monitors 141 to 149 indirectly measure the distribution of gas flowing on the substrate W.

Based on the measurement results, the controller 107 individually controls the openings or opening times of the valves 131 to 133. For example, when generated dust amounts measured by the film forming chamber monitors 141, 144, and 147 arrayed on the left line are larger than those measured by the film forming chamber monitors on the remaining lines, the controller 107 decreases the amount of gas supplied through the gas supply pipe 121 by decreasing the opening of the valve 131 or shortening its opening time.

The exhaust pipe monitor 161 measures a state in the exhaust pipe 151, whereas the exhaust pipe monitor 162 measures that in the exhaust pipe 152.

The exhaust pipe monitors 161 and 162 can be crystal oscillation monitors. As described above, this monitor can measure the mass of a film which is deposited on a detector formed from a crystal oscillator, similarly to that deposited on the substrate W, and can measure the film thickness based on the measured mass. In the atomic layer film forming apparatus having the exhaust pipe monitors 161 and 162, a thin film identical to one formed on the substrate W is formed on the detector from gases flowing through the exhaust pipes 151 and 152. The exhaust pipe monitors 161 and 162 indirectly measure the amounts of gases flowing through the exhaust pipes 151 and 152. In this manner, the exhaust pipe monitors 161 and 162 function as gas amount measurement units.

Based on the measurement results, the controller 107 individually controls the openings or opening times of the valves 131 to 133. For example, when a gas amount measured by the exhaust pipe monitor 161 is larger than that measured by the exhaust pipe monitor 162, the controller 107 decreases the amount of gas supplied through the gas supply pipe 121 by decreasing the opening of the valve 131 or shortening its opening time.

As described above, in the atomic layer film forming apparatus according to the embodiment, the film forming chamber monitors 141 to 149 measure a state on the substrate W in the film forming chamber 101. Based on the measurement results, the controller 107 individually controls the openings or opening times of the valves 131 to 133. For example, if a distribution in which a film is formed thick on the left side in the widthwise direction with respect to a direction in which a supplied gas flows is confirmed from the measurement results of the film forming chamber monitors 141 to 149, the controller 107 decreases the opening of the valve 131 or shortens its opening time to decrease the gas flow rate on the left side. Also, the controller 107 increases the opening of the valve 133 or prolongs its opening time to increase the gas flow rate on the right side. As a result, the atomic layer film forming apparatus copes with the distribution of the flow rate of gas in the film forming chamber 101 or that of the thickness of a film formed on the substrate W, which is measured by the film forming chamber monitors 141 to 149, canceling nonuniformity of the distribution.

In the above description, the three gas supply pipes 121, 122, and 123 are arranged on one side (first side) of the film forming chamber 101. However, the present invention is not limited to this, and two gas supply pipes may be arranged, or four or more gas supply pipes may be arranged.
In the above description, three film forming chamber monitors are arranged on each of the left, center, and right lines. However, the present invention is not limited to this, and for example, one film forming chamber monitor may be arranged on each line. Alternatively, two film forming chamber monitors may be arranged at two, right and left portions. It is also possible to set four or more lines parallel in a direction in which gas flows, and arrange or array film forming chamber monitors on each line.

As shown in Fig. 3, a plurality of gas supply pipes such as gas supply pipes 122a and 122b may be arranged in the vertical direction of the film forming chamber 101 at the gas supply portion on one side (first side) of the film forming chamber 101. It suffices to supply, for example, an oxidizing gas through the gas supply pipe 122a and a source gas through the gas supply pipe 122b. Note that valves 132a and 132b are attached to the gas supply pipes 122a and 122b, respectively.
Similarly, a plurality of exhaust pipes such as exhaust pipes 152a and 152b may be arranged in the vertical direction of the film forming chamber 101 at the exhaust portion on the other side (second side) of the film forming chamber 101. It suffices to exhaust, for example, an oxidizing gas through the exhaust pipe 152a and a source gas through the exhaust pipe 152b.

The same effects as those described above can also be obtained by individually controlling exhaust amounts through the exhaust pipes 151, 152, 152a, and 152b by the controller 107.
In the above description, the controller 107 individually controls the openings or opening times of the valves 131 to 133 based on the results of measurement by the film forming chamber monitors 141 to 149 and the exhaust pipe monitors 161 and 162. Alternatively, the controller 107 may control both the openings and opening times of the valves 131 to 133. Further, the controller 107 may control the openings or opening times of the valves 131 to 133 based on the results of measurement by the film forming chamber monitors 141 to 149 or the exhaust pipe monitors 161 and 162.

## Claims

1. An atomic layer film forming apparatus comprising:
a film forming chamber in which a substrate subjected to film formation is arranged;
a plurality of gas supply pipes which supply, from a first side of said film forming chamber to said film forming chamber, a gas containing a raw material for forming a thin film on the substrate;
a plurality of valves which are attached to said plurality of gas supply pipes;
an exhaust portion which evacuates an inside of said film forming chamber from a second side of said film forming chamber that faces the first side;
a film forming chamber state measurement unit which is arranged in said film forming chamber and measures a state on the substrate in said film forming chamber; and
a controller which individually controls at least one of openings and opening times of said plurality of valves based on a result of measurement by said film forming chamber state measurement unit.

2. An atomic layer film forming apparatus according to claim 1, wherein
said exhaust portion includes a plurality of exhaust pipes,
the atomic layer film forming apparatus further comprises a plurality of exhaust pipe internal state measurement units which are arranged on said plurality of exhaust pipes, respectively, and measure states in said plurality of exhaust pipes, and
said controller performs control based on results of measurement by said plurality of exhaust pipe internal state measurement units, in addition to the result of measurement by said film forming chamber state measurement unit.

3. An atomic layer film forming apparatus according to claim 1, wherein said film forming chamber state measurement unit includes at least one of a gas amount measurement unit which measures an amount of gas flowing on the substrate in said film forming chamber, a film thickness measurement unit which measures a thickness of the thin film, a refractive index measurement unit which measures a refractive index of the thin film, and a foreign substance measurement unit which measures a state of a foreign substance generated above the substrate.

4. An atomic layer film forming apparatus according to claim 1, wherein said exhaust pipe internal state measurement unit includes a gas amount measurement unit which measures an amount of gas flowing through said exhaust pipe.
